# EUROPEAN PATENT APPLICATION

(11) **EP 2 138 753 A1**
(43) Date of publication of application: **30.12.2009**
(21) Application number: 08738744.5
(22) Date of filing: 24.03.2008
(51) Int. Cl.: F21S 2/00, H01L 33/00

(54) **LIGHT BOX**

(30) Priority: 22.03.2007 JP 2007075274; 28.08.2007 JP 2007220973
(71) Applicant: The Furukawa Electric Co., Ltd., Chiyoda-ku Tokyo 100-8322 (JP)
(72) Inventor: OIDE, Ken, Tokyo 100-8322 (JP); ISHII, Syunji, Tokyo 100-8322 (JP); IKEDA, Hideyuki, Tokyo 100-8322 (JP)
(74) Representative: Kleimann, Tobias
(86) International application number: PCT/JP2008/055405
(87) International publication number: WO 2008/114882

(57) **Abstract**

[PROBLEMS] To provide a thin light box employing a light source of strong directivity such as an LED, or a light box in which occurrence of unevenness in surface illuminance is suppressed even when the number of LEDs is reduced by a factor of 4-9 as compared with prior art. [MEANS FOR SOLVING PROBLEMS] The light box (1) comprises a plurality of spot light sources (4), and a light reflector (21) having recesses (22) surrounding the spot light sources (4), respectively. The spot light sources are inserted into insertion holes (23) formed in the bottom of the containing recesses (22), respectively. When the incident angle of light exiting the spot light source (4) is 0° and the spot light sources (4) are spaced apart by 350 mm, the illuminance is 15000 cd/m2 or less and the light exiting the spot light source (4) is reflected partially or entirely on the inner surface of the containing recesses (22) before offering illumination.

## Description

### Field of the Invention

The present invention relates to a light box, and in particular, an internal lighting type light box using point like light sources such as LEDs (Light Emitting Diodes), and in more detail, a light box that can be suitably used for electrically illuminated signboards, internal lighting type signs, backlights for liquid crystal displays, and illuminating appliances.

### Background of the Art

Conventionally, straight tube type light sources such as fluorescent lamps and cold cathode ray tubes have been used for inner-lighting type light boxes. However, the duration life for using the fluorescent lamp is short, and for example, it is said that the duration life of a general straight tube type fluorescent lamp of 40 W is around 12,000 hours, and with respect to light boxes such as signboards at convenience stores and stations mounted at a high level location, it is difficult to change the fluorescent lamps every time the fluorescent lamp becomes out of order, and therefore, all of the fluorescent lamps are changed once in a year, but there are problems such as the need for operations at a high level locations in the night.

In directly-underneath type backlights in liquid crystal displays of liquid crystal televisions, they use cold cathode ray tubes that are said to have long duration lives of around 50,000 hours. However, the cold cathode ray tubes have duration lives that end when the brightness becomes half, and consequently, there are problems in that the brightness becomes half after the 50,000 hours. Furthermore, since the cold cathode ray tubes are used by applying a high voltage as high as 1,000V, there are problems in that they tend to be troublesome due to the leakage electricity.

Consequently, an inner-lighting type light box which use LEDs as the light source has been proposed, recently (for example, refer to Patent Document 1). The light box that use LEDs as the light source is constructed by arranging a plurality of LEDs densely on a light reflecting surface having a planar shape (LED lamps having a diameter of 3 mm are arranged with 10 mm intervals), and placing a light transparent plastic board in front of the LEDs and the light reflecting surface. By using LEDs as the light source as in the above, it is able to reduce the lowering of the brightness after the 50,000 hours compared with the case that use cold cathode ray tubes, and to reduce the consuming power and the heat by lowering the voltage used.

Patent Document 1: Japanese patent un-examined publication 10-83148

### Disclosure of the Invention

### Problems to be Solved by the Invention

However, since the directionality of the radiated light of LEDs are strong, if LEDs are arranged on a planar light reflecting surface, light areas where the LED light directly reaches on the light box surface and dark areas where the light does not reach are originated, and therefore, there was a problem in that an irregularity in the illuminating intensity is observed at the surface of the light box.

With only dispersing the emitted light by providing a concave lens or a prism in front of LEDs, or using a light reflecting plate having a light dispersing reflectivity of a visible light 90% or more together with the LEDs, as for light boxes having a thin thickness or light boxes having reduced numbers of LEDs, there was a problem in that it could not prevent irregularities in the illuminating intensity from originating at the surface of the light box.

The present invention is achieved in view of the above problems, and its objective is to provide a light box having a thin thickness using light sources with a strong directionality of light, such as LEDs, and a light box that can suppress the irregularities in the illuminating intensity at the surface from originating even when the number of the LEDs is reduced to 1/4 to 1/9 of the prior art.

### Means to Solve the Problems

In order to attain the above described object of the invention, the light box of the invention is comprised of: a point like light source;
a light reflecting plate arranged around said point like light source;
a light diffusion surface plate having light transmissive property and arranged to face said light reflecting plate; a case having an opening formed in a direction of light and for housing at least said point like light source and said light reflecting plate inside; and wherein
a receiving concave portion is formed with said light reflecting plate, said point like light source is allocated inside said receiving concave portion, an injection angle of the light from said point like light source is 0°, and a brightness is less than or equal to 15000 cd/m² when spaced apart a distance of 350 mm, and a part or all of the light from said point like light source is provided for an illumination after reflecting at an inner surface of a circumferential wall of said receiving concave portion.

The point like light source is a light source module, which is arranged in an array on a circuit board, or modularized with a single or a plurality of point like light sources.

The point like light source preferably comprises an LED with a point like light emitting portion sealed by a sealing member, and the sealing member is preferably equipped with a light diffusion means.

Although the shape of the sealing member is not limited to, but the sealing member preferably comprises a bombshell type sealing member equipped with a light diffusion, or a prism type or a concave lens type sealing member. Furthermore, separate prism or concave lens is preferably arranged in front of the LED.

The point like light source is preferably equipped with a light flux control member to scatter the light from the point like light source and emit same.

The point like light source preferably comprises a light source module including a LED mounted on a board sealed by a sealing member, and a light flux control member to scatter a light emitted from the LED and to emit same, arranged on a surface of the sealing member through which a light axis emitted from the LED is positioned.

The point like light source module is preferably formed such that the light generated from the light emitting portion is emitted through a light flux control member, or the light generated from the light emitting portion is emitted through the sealing member and the light flux control member in this order, the light flux control member includes a light incident face into which the light from the light emitting portion enters the light flux control member, and a light control emitting face to control the light emission from the light emitting portion, concerning the light ranging between a direction to which at least maximum strength light is emitted from the LED and a direction to which one half of strength light of the maximum strength light is emitted, the light control emitting face is formed to satisfy a relation between θ1 and θ5 to be (θ5/θ1) > 1 excluding the light in a vicinity of a reference plane, where the angle formed between the light entering the light flux control member and reaching the light control emitting face, and the line parallel to a reference light axis of the light source module and passing the reaching point is represented by the angle θ1, and an angle of the emission of the light from the light control emitting face is referred to as the angle θ5, and the light control emitting face is formed to be the shape in such fashion that a value of θ5/θ1 is gradually reduced as the θ1 increases.

The receiving concave portion is preferably formed in a reversed multi sided pyramid shape or a reversed multi sided pyramid shape, with a top thereof cut, surrounding said point like light source. Furthermore, if it is formed as a reversed multi sided pyramid shape having its narrow portion cut-off, it is more preferable to have a bottom portion.

It is preferable that the apex portion of said receiving concave portion is respectively connected to an apex portion of an adjacent receiving concave portion, and an apex portion of said receiving concave portion is located on a location at or below a bisection point of a distance from an emitting portion of said point like light source to said light diffusion surface plate, and at or above an emitting portion of said point like light source. More specifically, preferably, it is less than or equal to the distance of a bisection point and greater than or equal to a trisection point.

The scatter reflectivity of a visible light in the light reflecting plate is preferably at least 80%. The light reflecting plate preferably comprises a thermoplastic resin film or sheet which has fine foams or pores having an average diameter within the range from at least wavelength of the light to 50 µm inside thereof. Furthermore, the thermoplastic film or sheet preferably comprises a thermoplastic polyester foam having a thickness of within the range of from 150 to 2000 µm, and a specific gravity of within the range of from 0.1 to 0.7.

The total light ray transmissivity of the light diffusion surface plate is preferably, 20-70%, and more preferably, 30-60%.

The depth distance of said case is preferably formed in a range of 40-60 mm, and said plurality of point like light sources are arranged preferably in a matrix having intervals of longitudinal and lateral directions respectively in a range of 80-120 mm. The depth distance in this case means the distance from an inner surface of the bottom of the case to the light diffusion surface plate (hereinafter the same).

More preferably, the depth distance of said case is formed in a range of 20-40 mm, and said plurality of point like light sources are arranged in a matrix having intervals of longitudinal and lateral directions respectively in a range of 40-80 mm.

### Effect of the Invention

According to the light box of the present invention, excellent advantageous effects are achieved such as suppressing the origination of the irregularities in the illuminating intensity at the surface, even for a light box having a thin thickness using light sources having strong directionalities of the light, such as LEDs, and even if the number of the LEDs is reduced to 1/4-1/9 of the prior art.

Furthermore, since the receiving concave portion of the light reflecting plate is formed in a reversed multiple angle corn shape or a reversed multiple angle corn shape with a top thereof cut, the light reflected at the receiving concave portion reflects effectively at the side surface of the receiving concave portion, and since a large amount of the light even reaches onto the spaces between the light sources where the light intrinsically does not reach much, by producing synergistic effects with the sealing member and the light flux control member provided at forefront of the point like light sources in the present invention, the present invention achieves excellent advantageous effects, such as suppressing the origination of the irregularities in the illuminating intensity at the surface while achieving a thinner light box, even if the number of the point like light source is small.

Moreover, since the light reflecting plate of the present invention becomes closer to the light diffusion surface plate as moving away from the light sources, it contributes to reducing the irregularities in the light by making the light that did not transmit the light diffusion surface plate and that returned to the inside to return to the light diffusion surface plate side again effectively.

### Brief Description of Accompanying Drawings

Fig. 1 is a partially-cut top view of the main region of the first embodiment of the light box according to the present invention.
Fig. 2 is a cross-sectional view of the main region in Fig. 1.
Fig. 3 is a cross-sectional view showing a modification example of the light flux control member of the light source module in Fig. 1.
Fig. 4 is a magnified illustrative cross-sectional view showing another example of the main region of the light source module in Fig. 1.
Fig. 5 is a similar figure with Fig. 4, illustrating the light flux control member in Fig. 4.
Fig. 6 is a partially-cut top view of the main region of the second embodiment of the light box according to the present invention.
Fig. 7 is a cross-sectional view of the main region in Fig. 6.
Fig. 8 is a partial cross-sectional view showing another example of the main region of the receiving concave portion in Fig. 6.
Fig. 9 is an illustrative diagram showing an example of the method for manufacturing the light reflecting plate in Fig. 6.

### Detailed Description of Preferred Embodiments

Hereinafter, the present invention will be described together with the embodiments shown in the drawings.

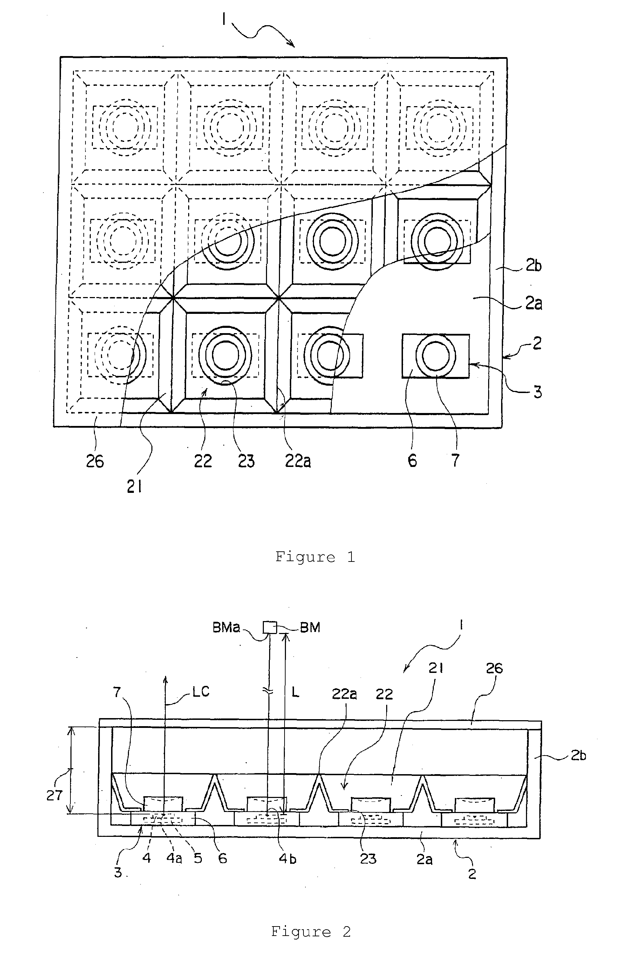

Fig. 1 and Fig. 2 show a first embodiment of the light box according to the present invention, and Fig. 1 is a partially-cut top view of the main region and Fig. 2 is a cross-sectional view of Fig. 1.

In the exemplary light box according to the first embodiment, a single point like light source is made into a module, and the modules are arranged in an array as the plurality of point like light sources.

As shown in Fig. 1 and Fig. 2, the light box (an illuminating apparatus having a surface light source) according to the first embodiment has a case 2 in which openings are formed in the side where the lights (an upwards direction in Fig. 2). The case 2 is comprised of a planar type bottom board 2a forming a rectangular shape, and four side boards 2b that stands up on four sides of the bottom board 2a, and is formed in a box outlook having a rectangular top view in which openings are provided in the upper region in Fig. 2 which is at the output side of the whole outlook. As for the case 2, it may be of any kind that is able to receive at least a plurality of point like light sources and a light reflecting plate 21 in its inside. The light diffusion surface plate 26 has preferably, the total light ray transmission rate of 20-70%, and more preferably, 30-60%.

Examples of the material for said case 2 include a steel board, an aluminum board, and a thermoplastic resin. Among those, a steel board, an aluminum board, an acrylic board, and a molded product are preferred since they exhibit good mechanical strength, antiweatherability, heat resistivity, impact resistivity, etc.

As for the thickness distance (the height of the entire lightbox), 40-60 mm is preferable since it is a level required for the facade signboards at convenience stores. Furthermore, 20-40 mm is preferable considering that it is a level required for backlights in liquid crystal televisions.

Moreover, considering the heat dissipation and the dampening of the expansion and shrinking of each of the members, it is preferable to enlarge the size of the hole of the insertion holes 23 of the light reflecting plate 21, that will be described later, 1 mm or more larger for each sides compared with the sides of the inserting-through region of the light source.

At the bottom of the case 2, light source modules 3 are arranged in a matrix shape as a plurality of point like light sources.

The light source module 3 according to the first embodiment is made by modularizing a single point like light source, and is arranged to include an LED 4 having a single point-type emitting portion 4a, and more specifically, a board 5 (circuit board) on which an LED chip is implemented is sealed with a sealing member 6 so that it forms a planar shape as a whole, and a light flux control member 7 to scatter the light from the LED 4 on a surface located on a light axis LC of the light from the LED 4 (the forward direction of the light at the center of the three-dimensional light flux output from the LED 4; shown with an arrow in Fig. 2). As for the light flux control member 7, those that can scatter the light from the LED 3 uniformly and smoothly for output are preferable.

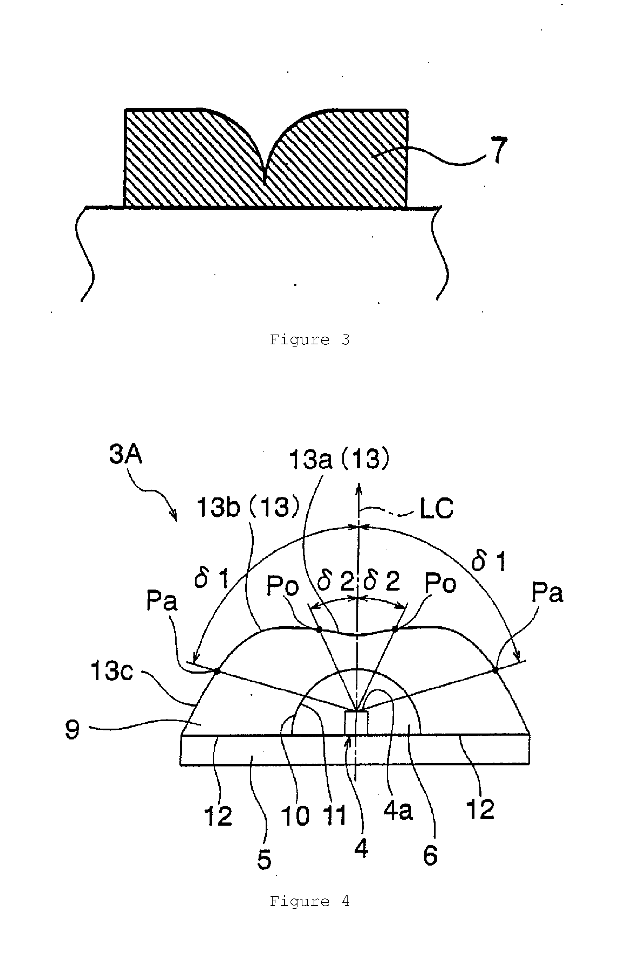

As for the shape of the light flux control member 7, it only requires to be a shape that can scatter the light from the LED 4 for output, and For example, the light flux control member has a shape like a disk and the upper face of the upper portion of which looks like a partially defect sphere. In addition, the light flux control member may have a shape like a disk, the upper face of the upper portion of which looks like a partially defect sphere, and the end edge of the upper face of the upper portion of which has a smoothly curbed portion. Further, the light flux control member may have a shape like a disk, and the lower face of the upper portion of which looks like a partially defect sphere. The light flux control member may also have a shape looks like a disk, and the upper face of the upper portion of which has a cone-shaped concave portion with the bottom positioned in the center thereof. The light flux control member may also have a shape looks like a disk, the upper face of the upper portion of which has a parabolic concave curve from the peripheral border of the portion toward the bottom positioned in the center thereof. The light flux control member also may have a shape like a disk, the upper face of the upper portion of which has a sharp concave portion with the bottom positioned in the center thereof, and the side portion of the upper face of which has a respective square corners (refer to Fig. 3).

The surface of the light flux control member 7 may be etched to be like a frost glass to allow an additional function of the light scattering.

As the material of the light flux control member 7, such transparent resin material as PMMA (polymethylmethacrylate), PC (polycarbonate), EP (epoxy), or transparent glass are preferable.

The module is a circuit component assembling wired circuit elements, and manufactured according to the standardized size, thus having the standardized plug in terminal or the terminal enabling to be soldered.

As for the light source module 3, specific examples include a module that uses Shining Eye (L) (a product name made by Koha Co. Ltd.) or LEC (Light Enhancer Cap; Enplas Display Device Corporation made) as the light flux control member 7.

As for the light source module 3, it is preferably formed so that the incident angle of the light from the LED 4, that is, a single point like light source, is 0° and the brightness is 15000 cd/m² or less at a location where a distance of 350 mm is spaced apart in a situation where a light diffusion surface plate 26 to be described later is detached (hereinafter simply referred to as the "brightness of LED 4"), and a part or all of the light from a single LED 4, which is a point like light source, is dispersed to be used for the illumination after reflecting at the inner surface of the receiving concave portion 22 of the light reflecting plate 21, which will be described later.

The upper limit of the brightness of the LED 4 is 15000 cd/m², and more preferably, 2000 cd/m², and it is therefore possible to reduce the brightness of the light that directly reaches to the light diffusion surface plate 26. Furthermore, the lower limit of the brightness of the LED 4 is 100 cd/m², and more preferably, 300 cd/m² . Even if the above brightness is low, it only requires that the lights in the diagonal and lateral directions and is dispersion-reflected at the light reflecting plate 21, that the scattered light reaches to the light diffusion surface plate 26, and that the irregularities in the light at the surface of the light box 1 is reduced.

The light that reached to the light diffusion surface plate 26 transmits to the outside based on the total light ray transmissivity, and almost all of the rest of the light returns back to the inside of the case 2, but upon the returned backlight is dispersion-reflected at the light reflecting plate 21 to be described below, it contributes to further reducing the irregularities in the light at the surface of the light box 1, because the farther the light reflecting plate 21 is from the light source, the closer it is to the light diffusion surface plate 26.

The brightness in this context indicates a value measured using a brightness meter by placing a distance L of 350 mm between a location located on the light axis LC of the surface of the sealing member 6 which is the top portion 4b of the LED 4 and the measuring segment BMa of the brightness meter BM. It is noted that the light is directly measured by detaching the light diffusion surface plate 26.

As the color of the emitted light from the point like light source, various kind of color such as red, green, blue, yellow, white or the like can be used by itself or in combination with the other.

The brightness of the point like light source can be appropriately selected, considering the scope of the invention according to the conditions.

Furthermore, as for the light source module 3, it may be modularized with a plurality of point like light sources.

The light source module 3 is arranged in a matrix shape in which its emitting portion 4a is oriented to the opening side and the longitudinal and lateral intervals are equally spaced. However, the longitudinal and lateral intervals of the light source module may be different due to the manufacturing reasons of the light box.

As for the longitudinal and lateral intervals upon arranging the light source modules 3 in a matrix shape, it is preferable to form each of them equal if the depth distance of the case 2 is formed in a range of 40-60 mm, but even if they cannot be made equal due to the size of the light box, it is preferable to set the intervals such that the maximum interval is in a range of 80-120 mm. As for the longitudinal and lateral intervals, it is preferable to form each of them equal if the depth distance of the case 2 is formed in a range of 20-40 mm, but even if they cannot be made equal due to the size of the light box, it is preferable to set the intervals such that the maximum pitch is in a range of 40-80 mm. As previously described, the depth distance of the case 2 in this context indicates a distance from the inner surface of the bottom of the case 2 to the light diffusion surface plate 26, that is, the distance between the bottom board 2a of the case 2 and the light diffusion surface plate 26.

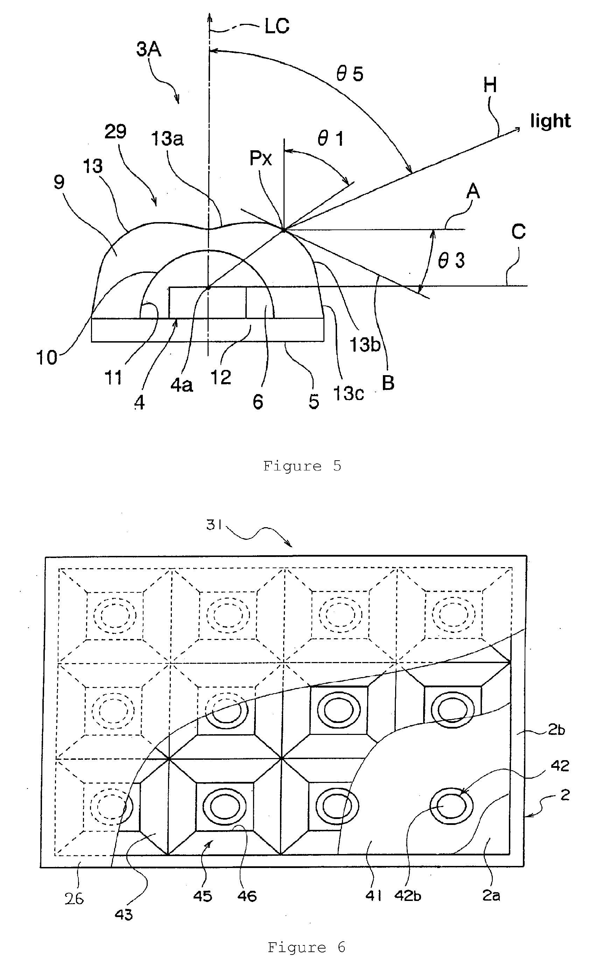

As for the light source module 3, the light source module 3A shown in Fig. 4 and Fig. 5 may be used. The light source module 3A is formed to output the light from the emitting portion 4a, which is a point like light source of the LED 4 implemented on the board 5 (circuit board), via the light flux control member 9, or the light from the emitting portion 4a, which is a point like light source of the LED 4 implemented on the board 5, via the sealing member 6 and the light flux control member 9 in this order.

The sealing member 6 is formed to hemispherically cover the light emitting portion 4a of the LED 4 mounted on the board 5.

As the material of the light flux control member 9, such transparent resin material as PMMA (polymethylmethacrylate), PC (polycarbonate), EP (epoxy), or transparent glass are preferable.

The light flux control member 9 has a circular shape in horizontal plane. As depicted in Fig. 4, which is a cross sectional view, the light flux control member 9 has a concave portion 11 inside thereof (the lower side in Fig. 4) so as to closely cover the light emitting face 10 of the LED 4. The concave portion 11 is formed at the inner side of the light flux control member 9 (the lower side in Fig. 4) to be like the hemispherical in the center thereof. The hemispherical shape of the concave portion 11 of the light flux control member 9 corresponds to the shape of the light emitting face 10 of the LED so that the concave portion 11 is closely fit to the light emitting face 10. The lower side of the light flux control member 9, which has a flat face portion 12, is adhesively fixed to the board 5 mounting the LED 4. Thus, the concave portion 11 of the light flux control member 9 is adhesively fixed to the light emitting face 10 of the LED 4.

The light flux control member 9 has a light control emitting face 13 at the outer surface thereof. The light control emitting face 13 has the first emitting face 13a, which is located at the prescribed region with the light axis LC as its center, and the second emitting face 13b which is continuously formed at the peripheral of the first emitting face 13a. The first emitting face 13a has a smoothly and downwardly protruding curbed shape (i.e., convex downward). In other words, an upper part of the sphere is cut and the concave shape is formed in the center portion thereof. The second emitting face 13b is formed continuously to the first emitting face 13a, which has a curbed shape of smooth and convex. The second emitting face 13b has a hollow disk shape in the horizontal plane which surrounds the first emitting face. The first emitting face 13a is smoothly connected to the second emitting face 13b. The connecting portion of the first emitting face 13a and the second emitting face 13b forms the point of inflexion Po.

The third emitting face 13c is formed at the outer peripheral side of the second emitting face 13b forming the light control emitting face 13, which connects the second emitting face 13b to the flat face portion 12. Although the third emitting face 13c is shown to have a straight slant face in Fig. 4, the shape of the third emitting face is not limited to the above described feature. The shape of the third emitting face may be a curved face as far as it does not prevent the wide and smooth emitting of the light flux control member 9. Here, the angle formed between the light axis LC and the line connecting the light source to the connecting point Pa of the emitting faces 13b and 13c is represented by δ1. The angle formed between the light axis LC and the line connecting the light source to the point of inflexion Po is represented by δ2.

Here, the light control emitting face 13 of the light flux control member 9 is described in detail with reference to Fig. 5.

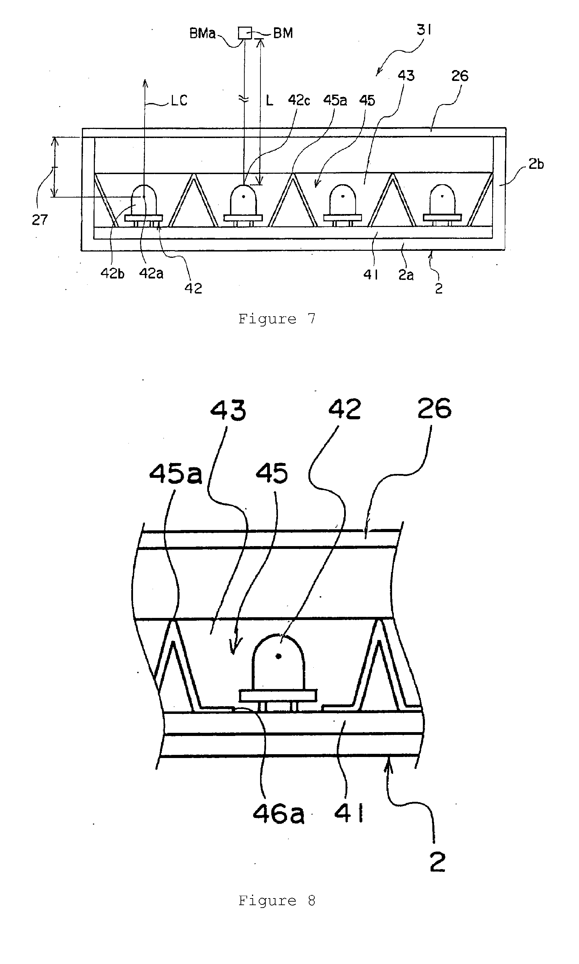

As depicted in Fig.5, the horizontal face perpendicular to the light axis LC of the LED 4 is considered as the reference plane C. The position where the light H emitted from the LED 4 and propagated in the light flux control member 9 emits from the light control emitting face 13 is considered as the position Px (i.e., the intersection of the light control emitting face 13 and the light H). The line drawn parallel to the reference plane C from the position Px is represented by the line A. The angle formed between the light incident in the light flux control member 9 and reaching the light control emitting face 13, and the line parallel to the light axis LC and passing the point in which the above described light reaches at the light control emitting face 13 is represented by the angle θ1. The angle formed between the tangent line B in the contour of the light control emitting face 13 at the position Px, and the line A is referred to as the angle θ3. Where the position Px is the position where the light H from the LED 4 emits from the light control emitting face 13. The angle of the emission of the light H emitting from the light control emitting face 13, which propagates in the light flux control member 9 from the LED 4 , is referred to as the angle θ5 (i.e., the angle formed between the light axis LC and the light H emitting from the light control emitting face 13),in Fig.7.

The light control emitting face 13 depicted in Fig. 7 is formed to satisfy the relation between θ1 and θ5 to be (θ5/θ1) > 1, within the prescribed region including the angle region (excluding the light in the vicinity of the normal line (the light axis LC in Fig. 7)) between the direction to which at least maximum strength light is emitted from the LED 4 and the direction to which one half of strength light of the maximum strength light is emitted. Where the direction to which at least maximum strength light is emitted means the direction along the light axis LC, as well as the direction along the normal line of the reference plane C, and the prescribed angle region is within the angle region of θ1 < θ1. The light control emitting face is formed to be the shape so that the value of θ5/θ1 is gradually reduced as the θ1 increases.

When the coefficient of the diffusion degree of the light flux control member 9 is represented by α, θ5 is expressed within the region of θ1 < δ1 by (1+((δ1-θ1)×α)/ δ, (θ1 <δ1). Furthermore, θ 3 is expressed within the region of θ1 < δ1 by tan⁻¹((sinθ5-n· sinθ1) /(cosθ5-n· cosθ1)), (n is the refraction index of the light flux control member). The vicinity of the above described normal line (i.e., light axis LC in Fig. 5) means that θ1 is preferably within a range of ±5 degrees, for example.

Thus obtained θ3 is gradually reduced, as θ1 increases from the vicinity of light axis LC until θ1=δ2. In the region of θ1>δ2, θ3 gradually increases, as θ1 increases. Then, when θ1 becomes to coincide with δ1, it satisfies θ3 =θ1.

The function of the light control emitting face 13 in the light flux control member 9 is described. As depicted in Fig. 5, the light H from LED 4 is propagated inside of the light flux control member 9, and then emits from the light control emitting face 13 to the outside (in the air) according to Snell's law. In this case, the light flux of the LED 4 emitted from the light flux control member 9 is not partially emitted at the direct overhead of the LED 4, but uniformly and smoothly expanded and emitted into the irradiating region, comparing with the light flux emitted from the light flux control member simply formed in hemisphere shape.

More specifically, preferably, the light source module 3A may be formed such that the light generated from the light emitting portion 4a as the point like light 3a source is emitted through the light flux control member 9. Alternatively, the light generated from the light emitting portion 4a as the point like light 3a source is emitted through the sealing member 6 and the light flux control member 9 in this order. The light flux control member 9 may includes the light incident face (the concave face of the concave portion 11) into which the light from the light emitting portion 4a of the point like light 3a source or the light from the light emitting portion 4a sealed by the sealing member 6 enters, and light control emitting face 13 to control the light emission from the light emitting portion 4a. Concerning light ranging between the direction to which at least maximum strength light is emitted from the LED 4 and the direction to which one half of strength light of the maximum strength light is emitted, the light control emitting face 13 may be formed to satisfy the relation between θ1 and θ5 to be (θ5/θ1) > 1 excluding the light in the vicinity of the reference plane. Where the angle formed between the light reaching the light control emitting face 13, and the line parallel to the light axis LC of the light source module 3A and passing the reaching point is represented by the angle θ1, and the angle of the emission of the light from the light control emitting face 13 is referred to as the angle θ5. Furthermore, the light control emitting face may be formed to be the shape in such fashion that the value of θ5/θ1 is gradually reduced as the θ1 increases.

As the light source module 3A, specifically, the module in which LEC (Light Enhancer Cap: the product of Enplas Display Device Corporation) is used as the light flux control member 9 can be exemplified.

As for the light source module 3, 3A, it may be modularized with a plurality of point like light sources.

Returning back to Fig. 1 and Fig. 2, alight reflecting plate 21 is housed inside of the case 2. The light reflecting plate 21 is for reflecting the light from the light source module 3 which is a plurality of point like light sources, and is arranged to face the upper surface of the sealing member 6 of the light source module 3.

The light reflecting plate 21 includes a plurality of receiving concave portions 22 that surrounds each of the plurality of point like light sources and that surrounds the circumferences of each of the light flux control members 7 of each of the light source modules 3 in the first embodiment, and insertion holes 23 that can freely insert through the light flux control members 7 of the light source modules 3 formed at the center of the bottom of receiving concave portions 22. As for the shape of the insertion hole 23, it can be of any shape although it is a planar circle shape in the first embodiment.

The receiving concave portion 22 according to the first embodiment is formed as a reversed multi sided pyramid shape with the narrow portion cut-off (an upside down multi sided pyramid shape with the narrow portion cut-off; hereinafter referred to as a "truncated reversed multi sided pyramid shape"), and more specifically, is formed as a reversed quadrangle pyramid shape with the narrow portion cut-off (an upside down quadrangle pyramid shape with the narrow portion cut-off; hereinafter referred to as a "truncated reversed quadrangle pyramid shape"), and the top portions 22a of each of the receiving concave portion 22 are arranged so that they locate in a single plane. Needless to say, the receiving concave portion 22 may be a reversed multi sided pyramid shape. Each of the top portions 22a of the plurality of receiving concave portions 22 is preferably connected to the top portion 22a of the adjacent receiving concave portion 22. The top portions 22a of the adjacent receiving concave portions 22 may be arranged to push together.

In other words, in the light box 1 according to the first embodiment, the light reflecting plate 21 is arranged so that it fits into the space between each of the light source modules 3, and the light flux control member 7 of each of the optical source modules 3 projects at the insertion hole 23 provided at the bottom of the receiving concave portion 22 which has a truncated reversed multi sided pyramid shape. As for the size of the insertion holes 23, it is preferable to form them 1 mm or more larger at one side of them, compared with the size of the insertion-through region of the light source module 3.

Therefore, the light source modules 3 are arranged and wired in advance at the inner surface of the bottom board 2a of the case 2, in order for the light flux control member 7 of the light source module 3 to project in the direction of the openings of the case 2 from the insertion hole 23 of the bottom of each of the receiving concave portion 22.

As for the shape of the receiving concave portion 22, it is not limited to the truncated reversed quadrangle pyramid shape, and it may be other truncated reversed multi sided pyramid shape, such as a truncated reversed triangular pyramid shape, a truncated reversed pentangular pyramid shape, and a truncated reversed hexangularal pyramid shape. The shape of the receiving concave portion 22 may be appropriately selected among various kinds such as reversed multi-sided pyramid, cup type, pot type, hemisphere type, semielliptical sphere with the through hole in the bottom as insertion hole 23, depending on the specification or design concept.

The vertex angle of the vertex 22a of the receiving concave portion 22 formed in a truncated reversed quadrangle pyramid shape according to the first embodiment is 60-120°, and preferably, 80-100°. The height of the vertex 22a is greater than or equal to the height of the emitting portion 4a of the light source, and is less than or equal to the bisection point of the distance from the emitting portion 4a to the light diffusion surface plate 26, and preferably, less than or equal to the bisection point and greater than or equal to the trisection point.

It is preferable to space apart 1 mm or more at a space between the peripheral wall of the insertion hole 23 of the light reflecting plate 21 and the light flux control member 7 of the light source module 3, for the purpose of dissipating the heat originated at the LED 4, etc., and relieving the mismatch of the positions of the case 2 and the light reflecting plate 21 due to the differences in the coefficient of thermal expansion.

The light reflecting plate 21 is preferably formed by thermoplastic resin film or sheet which has fine foams or pores having an average diameter within the range from at least wavelength of the light to 50µ m inside thereof.

As the material of the thermoplastic resin film or sheet, there are exemplified as follows, for example: general purpose resin such as polyethylene, polypropylene, polystyrene, polyvinyl chloride, polychlorinated biphenyl, polyethylene terephthalate, polyvinyl alcohol, engineering plastic such as polycarbonate, polybutylene terephthalate, polyethylene naphthalate, polyamide, polyacetal, polyphenylene ether, ultrahigh molecular polyethylene, polysulfone, polyether sulfone, polyphenylene sulfide, polyallylate, polyamide-imide, polyether imide, polyether ether ketone, polyamide, polytetrafluoroethylene, liquid crystal polymer, fluorine rsin, or copolymer or mixture of the above. Polyester, polyphenylene sulfide, polypropylene, or cyclopolyolephine is preferable in the above described, since they are excellent in heat resistance, impact resistance or the like.

Antioxidant, ultraviolet absorber, lubricant, pigment, enhancement or the like can be added to the thermoplastic resin. In addition, a coating layer containing the above described addition agent may be applied.

More specifically, as an example of the thermoplastic resin film or sheet, polyester based foam sheet (for example, MCPET (registered trademark) manufactured by Furukawa ElectricCo.Ltd) can be used. The above described polyester based foam sheet is the sheet having a foam diameter of up to 50µm therein in which an extruded sheet of the thermoplastic polyester is caused to impregnate carbon dioxide gas under high pressure, and then heated and foamed. In addition, cyclopolyolephine based foam sheet having a foam diameter of up to 50µm therein can be applied.

As a preferable example of the material forming the light reflecting plate 21, there can be exemplified thermoplastic film or sheet containing filler in which a number of voids are formed on the filler functioning as the core. In this case, a porous stretched film or sheet with a number of voids formed on the filler functioning as the core is preferable, in which the film or sheet is manufactured by the processes that an un-stretchedfilmor sheet containing fillers is formed, and then the un-stretched film or sheet is stretched.

Thickness of the light reflecting plate 21 is preferably within the range of from 150 to 2000 µm. With the thickness range of 150 to 2000 µm, the light reflecting plate has rigidity, and few light leaks to the back side of the light reflecting plate 21.

The specific gravity of the light reflecting plate 21 is preferably within the range of from 0.1 to 0.7. With the specific gravity of over 0.7, the light reflecting plate becomes transparent, and a lot of light leak to the back side of the light reflecting plate 21, thus enlarging the light loss.

The diffuse reflectivity of the visible light in the light reflecting plate 21 is preferably at least 80%. With the diffuse reflectivity of at least 80% in the light reflecting plate 21, the scattered reflection effect of the light source is improved.

Meanwhile, the diffuse reflectivity of the visible light is a ratio of the diffuse reflective light flux to the incident light flux. More specifically, the diffuse reflectivity is measured by the spectrophotometer with the wavelength of 555nm, and is obtained as the relative value to the standard value, when the diffuse reflectivity of the white plate with fine powder of barium sulfate fixed thereon is 100%. As the spectrophotometer, UV-3100PC (the product name of Shimadzu Corporation) can be used, for example.

As for the manufacturing method of the light reflecting plate 21, it may be formed integrally by press processing the film or the sheet, as in food trays. In this case, it is formed integrally so that the top portion 22a of each of the receiving concave portions 22 is connected to the top portion 22a of the adjacent receiving concave portion 22. Alternatively, it may be assembled as in parquets. Furthermore, since it is housed in the case 1, each of the receiving concave portions 22 may be formed individually and may be housed in the case 1 so that each top portion 22a pushes together.

At the upper side of the light reflecting plate 21, a transmissive light diffusion surface plate 26 is allocated. The light diffusion surface plate 26 is fixed to the opening end of the case 2 with a double-sided adhesive tape, an adhesive agent, screws, etc., so that it shuts the opening of the case 2 and faces the light reflecting plate 21. Needless to say, it may be mounted onto the opening end of the case 2 freely detachably.

As for the light diffusion surface plate 26, those having a total light ray transmissivity in a range of 20-70% and a reflectivity in a range of 30-80% are used suitably, and examples include an acrylic resin board, a polycarbonate board, a glass cloth, and a vinyl chloride resin sheet. If the total light ray transmissivity is within a range of 20-70%, the amount of the light source required for obtaining the brightness of the light diffusion surface plate 26 is not too large and it does not transmit the light with strong orientation from the light source too much. In a case where the light box 1 is thin, it needs to set the total light ray transmissivity to around 30%, because the light diffusion surface plate 26 above the light source becomes too bright and originates irregularities in the illuminating intensity if the brightness of the LED 4, which is a light source, is as high as 15,000 cd/m², which is the maximum value and the total light ray transmissivity of the light diffusion surface plate 26 is as high as 70% of the maximum value. In other words, it is advantageous if the total light ray transmissivity approaches to the lower limit when the brightness of the light source is high and the total light ray transmissivity approaches to the upper limit when the brightness of the light source is low. It is noted that the total light ray transmissivity is a value obtained according to JIS K 7105-1981.

As shown in Fig. 2, the top portion 22a of the receiving concave portion 22 locates at a location below or on a bisection point 27 of a distance from the emitting portion 4a of the LED 4 to the light diffusion surface plate 26 and above or on the emitting portion 4a of the LED 4.

Hereinafter, the present invention will be described in detail with the Examples. However, the present invention is not limited to those examples.

### (Example 1) We made a light box 1 shown in Fig. 1 and Fig. 2.

The case 2 is made as a planar rectangular shape, which has a longitudinal distance (inner measurement) of 300 mm, shown in the up-and-down directions in Fig. 1, and a lateral distance (inner measurement) of 400 mm, shown in the left and right directions in Fig. 1, and has an opening in the upper portion having a depth distance of 60 mm, shown in up-and-down directions in Fig. 2. The thickness distance of the bottom board 2a and the side board 2b is made 4 mm each. At the upper surface of the bottom board 2a of the case 2 (the inner surface of the bottom of the case 2), total twelve of the light source modules 3 with three in the longitudinal direction and four in the lateral direction, which forms a plurality of point like light sources, are arranged in a matrix shape with mutually-crossing intervals of 100 mm in the longitudinal direction and intervals of 100 mm in the lateral direction.

As for the light source module 3, we used Shining Eye (L) (a product name made by Koha Co. Ltd.; Product No. FA003F001 - Serial Circuit - Dedicated Power Source 0.3 W/pcs).

The brightness of the light source module 3 was 400 cd/m², measured using a brightness meter when one of the light source module 3 was lightened and was spaced apart a distance L with the light diffusion surface plate 26 removed from the top portion 4b of the LED 4. The brightness was measured using a brightness meter made by Topcon Corporation (Model Name: BM7), and spaced apart a distance L of 350 mm from the top portion 4b of the LED 4 to the measurement section BMa of the brightness meter BM, as shown in detail in Fig. 2.

The light reflecting plate 21 has a shape in which the receiving concave portions 22 having truncated reversed quadrangle pyramid shapes are connected continuously in the longitudinal and lateral directions at their top portions 22a, and an insertion hole 23 is formed on the bottom of the receiving concave portion 22, and the light flux control member 7 of the light source modules 3 projects from the insertion holes 23. The top portion 22a of the truncated reversed quadrangle pyramid shape may be pushed together by the truncated reversed quadrangle pyramids.

The receiving concave portions 22 of the light reflecting plate 21 have truncated reversed quadrangle pyramid shapes, and their top portions 22a are successively connected with each other, and insertion holes 23 having circular shapes are opened at their bottom for inserting through the LEDs 4. As for the size, the longitudinal distance of the upper part of the receiving concave portion 22 of the light reflecting plate 21 is 100 mm, its lateral distance is 100 mm, the longitudinal distance of the bottom is 54 mm, its lateral distance is 54 mm, its depth distance is 23 mm, and the diameter of the insertion holes 23 is 30 mm (the gap between itself and the light flux control member 7 is 3.5 mm) .

As for the light diffusion surface plate 26, Acrylite (a product name of Mitsubishi Rayon Co., Ltd.; Color No. #430) was used, which is a milky white colored acrylic resin board having a longitudinal distance of 308 mm, a lateral distance of 408 mm, and a thickness distance of 3 mm. The total light ray transmissivity of the light reflecting plate 21 was 30%.

### (Comparative example 1)

A light box was formed which was similar to Example 1 except that the light reflecting plate 21 was not used. The light source modules 3 of Comparative example 1 had a brightness of 400 cd/m² measured using a brightness meter when one of them was lightened and spaced apart a distance of 350 mm from its top. Note that the light was directly measured with the light diffusion surface plate 26 removed.

### (Comparative example 2)

A light box was formed with a case 2 and a light diffusion surface plate 26 having the same size with those of Example 1 but with changed inside point like light sources.

A circuit board was arranged at the bottom of the case 2 (at an upper surface of the bottom board 2a), in which point like light sources were arranged in an array at a longitudinal interval of 40 mm and a lateral interval of 40 mm. The point like light sources were used with 70 of them in a matrix with 7 in a longitudinal direction and 10 in the lateral direction. As for the point like light source, Nichia Corporation made LEDs (Product No.: NSPW510CS, Directionality: 50°) were used at a consumption power of 0.104 W/unit. Light dispersing means for the LEDs, such as concave lenses and prisms, or a light reflecting plate were not used.

### (Comparative example 3)

The point like light sources of Comparative example 2 were used with 130 of them in a matrix of 10 in a longitudinal direction and 13 in a lateral direction with intervals of 30 mm in a longitudinal direction and intervals of 30 mm in a lateral direction.

Thereafter, evaluations were done for Example 1 and Comparative examples 1-3, using the following method.

In the evaluation, the illumination intensity at 10 locations were measured by lighting the light sources of the light box 1 of the Example 1 in a dark room and directly contacting the light receiving section of an illumination meter to the light diffusion surface plate 26. As for the illumination intensity measurement appliance, a General AA Class illumination intensity meter (model name 51002) made by Yokogawa Meters & Instruments Corporation was used for the measurement. As for the 10 measurement locations on the light diffusion surface plate 26, four locations above the light sources of the second row from the top were referred to as K1, K2, K3, and K4, three locations above between the light sources of the second row from the top were referred to as Y1, Y2, and Y3, and the three locations among the top region of the light reflecting plate 21 extending in the lateral direction between the light sources of the first row from the top and the light sources of the second row where it is crossed with the top region of the light reflecting plate 21 extending in the longitudinal direction were referred to as Y4, Y5, and Y6, and all of those locations were measured, respectively. Furthermore, the irregularities in the illumination intensity were observed with the visual observation from a location 3 m vertically spaced apart from the output surface.

The results for the measurement for Example 1 were 1104 lux at K1, 1120 lux at K2, 1124 lux at K3, 1105 lux at K4, 1101 lux at Y1, 1104 lux at Y2, 1103 lux at Y3, 1101 lux at Y4, 1100 lux at Y5, and 1105 lux at Y6. The irregularities in the illumination intensity were not observed with a visual observation from a location 3 m spaced apart in the dark room.

In contrast, the results for the measurement for Comparative example 1 were 1095 lux at K1, 1112 lux at K2, 1116 lux at K3 ,1095 lux at K4, 812 lux at Y1, 812 lux at Y2, 814 lux at Y3, 801 lux at Y4, 810 lux at Y5, and 805 lux at Y6. Significant irregularities in the illumination intensity were observed with a visual observation from a location 3 m spaced apart in the dark room.

With regards to the light box of Comparative example 2, the average illumination intensity was 1004 lux, as a result of measuring the illumination intensity for all of the 70 locations above the point like light sources by lighting the light sources of the light box 1 of Comparative example 2 in the dark room and directly contacting the light receiving section of the illumination intensity meter to the light diffusion surface plate 26. The average illumination intensity was 877 lux, as a result of measuring the illumination intensity at 54 locations of the center of the mutually adjacent four point like light sources (allocated at the four corners of the rectangular frame), that is, the intersecting points of between the rows and between the columns, such as the center of the total 4 light sources at the first row and the second row from the top and the first column and the second column from the left. Significant irregularities in the illumination intensity were observed with a visual observation from a location 3 m spaced apart in the dark room.

With respect to the light box of Comparative example 3, the average illumination intensity was 1540 lux, as a result of measuring at all of the 130 locations above the point like light sources by lighting the light sources of the light box 1 of Comparative example 3 in the dark room and directly contacting the light receiving section of the illumination intensity meter to the light diffusion surface plate 26. The average illumination intensity was 1140 lux, as a result of measuring the illumination intensity for the 108 locations at the center of the mutually adjacent four point like light sources (allocated at the four corners of the rectangular frame), that is, the intersecting points of between the rows and between the columns, such as the center of the total four light sources at the first row and the second row from the top and the first column and the second column from the left. Significant irregularities in the illumination intensity were observed with a visual observation from a location 3 m spaced apart in the dark room.

Generally, requirements for the case where a light box is used for a facade signboard of a convenience store are that the surface illumination intensity at all of the locations at the surface of the light diffusion surface plate 26 exceeds 1000 lux, the ratio of the most bright location to the most dark location is within two, and there are no irregularities in the illumination intensity when visually observed them placed out of doors at the night.

Therefore, as is apparent from the above evaluation results, Example 1 fully satisfies the requirements for functioning as a facade signboard, whereas Comparative examples 1-3 could not satisfy the requirements for functioning as a facade signboard.

Fig. 6 and Fig. 7 show a second embodiment of the light box 1 according to the present invention, Fig. 6 is a partially-cut top view of the main part, and Fig. 7 is a cross-sectional view of Fig. 6. Same numerals are assigned in the figure and the descriptions are omitted for identical or corresponding structures with the light box of the aforementioned first embodiment.

In the exemplary light box of the second embodiment, a plurality of point like light sources are arranged on the circuit board.

The light box 31 of the second embodiment includes a case 2 in which openings are formed in the direction of the light (upwards in Fig. 7), as is with the light box 1 of the aforementioned first embodiment.

A circuit board 41 having a planer shape is arranged at the bottom of the case 2. At the upper surface of the circuit board 41, LEDs 42 which consists of a plurality of point like light sources are mounted, and more specifically, the LEDs 42 are formed by molding onto the point-type emitting portion 42a to form a bullet shape with the sealing member 42b, such as epoxy resin and glass, to form LED lamps. These LEDs 42 are arranged in a matrix on the circuit board 41, and more specifically, on the upper surface of the circuit board 41, with the same intervals in the mutually crossing longitudinal and lateral directions. On the circuit board 41, a light reflecting plate 43 for reflecting the light from the LEDs 42 is arranged to face the upper surface of the circuit board 41.

The LEDs 42 as the point like light source of this second embodiment are formed such that the light emitting portion 42a is encapsulated by the sealing member 3b to be like the molded bombshell, and a light scatter means is provided for the sealing member 42b to cover the light emitting portion 42a. By thus provided light scatter means, the illumination device is formed so that the brightness of one of the plurality of LEDs 42 is to be up to 15000 cd/m², when the brightness is defined as that the incident angle of the light emitted from the LED is zero and 350 mm apart from the LED in a situation where a light diffusion surface plate 26 is detached (hereinafter simply referred to as the "brightness of LED 42"). In addition, the illumination device is formed so that a part or all of the light emitted from one of the LEDs 42 as the point like light source is reflected from the inner face of a receiving concave portion 45 described later of the light reflecting plate 43 to be scattered and supplied as the illumination.

Although the upper limit of the LED brightness is 15000 cd/m², 2000 cd/m² is preferable. With the above described LED brightness, the glare of the light source looked from the direct beneath can be much reduced. The lower limit of the LED brightness is 100 cd/m², 300 cd/m² is preferable. Even if the LED brightness is low, it is applicable that the light is scatter-reflected from the light reflecting plate 43 and widely pervaded in the horizontal direction.

When the sealing member 42b is formed by a transparent resin or glass, the light diffusion means is formed by the sealing member 42b with the surface blast-processed, the sealing member 42b with the surface etched, or the sealing member 42b in which the material forming the sealing member 42b is mixed with a scatter material such as light scattering glass. The etching in the present invention means a process to roughen the surface of the material, namely, a surface roughening treatment. As the method of etching, it can be appropriately selected depending on the material of the sealing member 42b in the followings: cutting, grinding, ultrasonic machining, laser such as excimer laser, electrical discharging machining, wet and dry etching, electron beam, sandblast, micro blast or the like.

The sealing member 42b may be formed to a prism type or concave lens type so that a part or all of the light from the light emitting portion 42a is scattered in the lateral direction of the sealing member 42b.

The point like light source may be provided with a light flux control member ( refer to reference numeral 7,9 in Fig. 3∼5 ) to expand and emit the light from the point like light source. Preferably, the light flux control member may uniformly and smoothly expand the light from the point like light source and emit same. The light flux control member may have the shape to enable to expand the light emitted from the point like light source and emit same. For example, the light flux control member has a shape like a disk and the upper face of the upper portion of which looks like a partially defect sphere. In addition, the light flux control member may have a shape like a disk, the upper face of the upper portion of which looks like a partially defect sphere, and the end edge of the upper face of the upper portion of which has a smoothly curbed portion. Further, the light flux control member may have a shape like a disk, and the lower face of the upper portion of which looks like a partially defect sphere. The light flux control member may also have a shape looks like a disk, and the upper face of the upper portion of which has a cone-shaped concave portion with the bottom positioned in the center thereof. The light flux control member may also have a shape looks like a disk, the upper face of the upper portion of which has a parabolic concave curve from the peripheral border of the portion toward the bottom positioned in the center thereof. The light flux control member also may have a shape like a disk, the upper face of the upper portion of which has a sharp concave portion with the bottom positioned in the center thereof, and the side portion of the upper face of which has a respective square corners (refer to Fig. 3). As an example of the above described light flux control member, LEC (Light Enhancer Cap: the product of Enplas Display Device Corporation) can be exemplified. The light flux control member may be arranged to cover the surface of the sealing member 42b. In this case, the light flux control member may have a shape in which a concave portion is provided on the lower face to fix the sealing member 42b therein.

The kind and shape of the point like light source are not specifically limited, and can be selected among the above described bombshell type LED (LED 42), surface mounted type LED or the like.

As the color of the emitted light from the point like light source, various kind of color such as red, green, blue, yellow, white or the like can be used by itself or in combination with the other.

The brightness of the point like light source can be appropriately selected, considering the scope of the invention according to the conditions.

The number of the point like light source received in single receiving concave portion 45 may be one or plural.

The receiving concave portion 45 to enclose each of the plurality of LEDs 42 is formed by the circuit board 41 and the light reflecting plate 43. The shape of the bottom of the receiving concave portion 45, formed by the circuit board 41 is quadrangle in the embodiment, however, any shape is applicable.

As for the receiving concave portion 45, as shown in Fig. 8, it may have a truncated reversed multi sided pyramid shape, that is, a shape having an insertion hole 46a in which an LED 42 formed at the center of the bottom of the receiving concave portion 45 can be freely inserted through. As for the shape of the insertion hole 46a, it is typically a planar circle shape but it may be of any shape.

The receiving concave portion 45 of the second embodiment is formed in a reversed multi sided pyramid shape, more specifically, a reversed quadrangle pyramid shape, and the top portions 45a of the receiving concave portions 45 are arranged to locate in a same plane. The top portions 45a of the plurality of receiving concave portions 45 are preferably each connected to the top portion 45a of the adjacent receiving concave portion 45.

More specifically, the light reflecting plates 43 are arranged to position between the LEDs 42, or the light reflecting plates 43 are arranged to place each of the LEDs 42 in the respective receiving concave portions 45 formed to be the reversed multi-sided pyramid.

Therefore, the LEDs 42 are arranged and wired to the circuit board 41 in advance so that they project in the direction of the surface located at the opening side of the case 2 from the bottom of each of the receiving concave portions 45.

As for the shape of the receiving concave portion 45, it is not limited to a reversed quadrangle pyramid shape, and other reversed multi sided pyramid shapes, such as a reversed triangular pyramid shape, a reversed pentangular pyramid shape, and a reversed hexangular pyramid shape may be possible. Furthermore, as for the shape of the receiving concave portion 45, it may be suitably selected according to the requirements, such as specifications and design concepts, from various shapes, such as a truncated reversed multi sided pyramid shape, a cup shape, a pot shape, a half sphere shape, a half ellipse sphere shape, comprising a through-hole at the bottom shown in Fig. 8 that forms an insertion hole 46a.

The apex angle of the top portion 45a of the receiving concave portion 45 formed in a truncated reversed quadrangle pyramid shape in the second embodiment is 60-120°, and more preferably, 80-100°. The height of the top portion 45a is greater than or equal to the height of the emitting portion 42a of the light source and is less than or equal to the height of a bisection point of a distance from the emitting portion 42a to the light diffusion surface plate 26, and more preferably, less than or equal to the height of the bisection point and greater than or equal to the height of a trisection point.

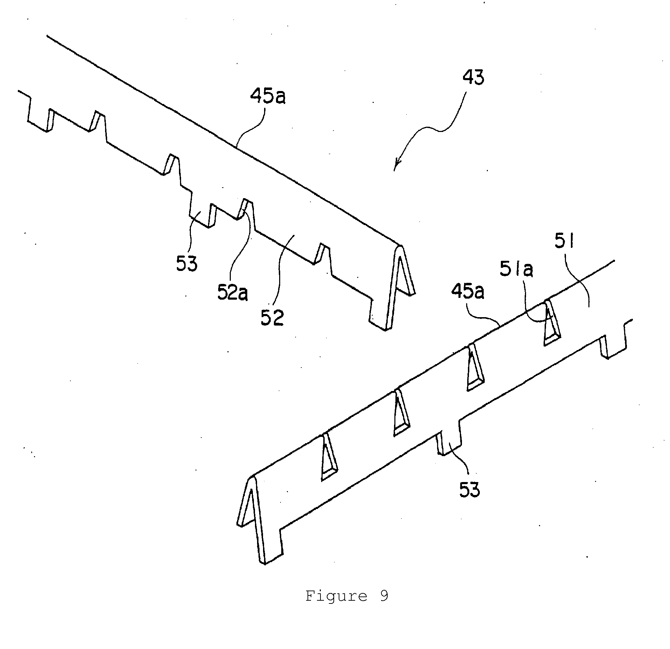

A manufacturing method of the light reflecting plate 43 of the second embodiment will be described now with reference to Fig. 9.

As depicted in Fig. 9, the film or sheet is stamped out, and then bent at the center thereof along the longitudinal direction to form a mountain like member. First concave fitting portions 51a having the depth of a half of height are formed with a specific pitch at the top 45a of the mountain-like member toward the bottom in order to produce the first mountain like member 51. In the same fashion, second concave fitting portions 52a having the depth of a half of height are formed with a specific pitch at the top 45a of the mountain like member toward the bottom in order to produce the second mountain like member 52. The first concave fitting portions 51a and the corresponding second concave fitting portions 52a are fitted each other to form the light reflecting plate with a plurality of reverse four sided pyramid type of the receiving concave portions 45. Furthermore, engaging members 53 protruding from the bottom are formed with a prescribed pitch at the bottom portion of the respective first and second mountain like member 51, 52. The engaging member 53 may be inserted into the slit (not shown) formed in the circuit board 41 and fixed thereto. Of course, the film or sheet may be pressed like a food tray to integrally form the light reflecting plate. In this case, an apex portion 45a of the receiving concave portion 45 is connected to an apex portion 45a of an adjacent receiving concave portion, thus integrally formed.

As for other arrangements, they are similar to the aforementioned light box 1 according to the first embodiment and the detailed descriptions are omitted.

According to such light box 31 of the second embodiment, it was able to confirm similar advantageous effects to the aforementioned light box 1 according to the first embodiment.

In other words, according to the light box 31 of the second embodiment, similar to the aforementioned light box 1 according to the first embodiment, there are advantageous effects, such as suppressing the occurrence of the irregularities in the surface illumination intensity even with thin light boxes using light sources having a strong directionality of the light, such as LEDs 42, and having the number of the LEDs 42 reduced to 1/4 to 1/9 of the prior art.

The light box of the present invention can be used for a variety of articles, such as for ceiling illuminations, facade signboards, and backlights in liquid crystal televisions.

The present invention is not limited to the above-described embodiments and may be modified with a variety of modifications if necessary.

## Claims

1. A light box comprising:
a point like light source;
a light reflecting plate arranged around said point like light source;
a light diffusion surface plate having light transmissive property and arranged to face said light reflecting plate;
a case having an opening formed in a direction of light and for housing at least said point like light source and said light reflecting plate inside; and wherein
a receiving concave portion is formed with said light reflecting plate, said point like light source is allocated inside said receiving concave portion, an injection angle of the light from said point like light source is 0°, and a brightness is less than or equal to 15000 cd/m² when spaced apart a distance of 350 mm, and a part or all of the light from said point like light source is provided for an illumination after reflecting at an inner surface of a circumferential wall of said receiving concave portion.

2. The light box according to claim 1, wherein said point like light source is a light source module, which is arranged in an array on a circuit board, or modularized with a single or a plurality of point like light sources.

3. The light box according to claim 1, wherein the point like light source comprises an LED with a point like light emitting portion sealed by a sealing member.

4. The light box according to claim 3, wherein the sealing member is equipped with a light diffusion means.

5. The light box according to claim 4, wherein the sealing member comprises a bombshell type sealing member equipped with a light diffusion, or a prism type or a concave lens type sealing member.

6. The light box according to any one of claims 1-5, wherein said point like light source includes a light flux control member to scatter the light from its emitting portion.

7. The light box according to claim 2, wherein said light source module is provided with a light flux control member formed by sealing a board in which an LED is implemented with a sealing member to scatter the light from the LED to emit on a surface located on an optical axis of the light from the LED.

8. The light box according to claim 2, wherein the point like light source module is formed such that the light generated from the light emitting portion is emitted through a light flux control member, or the light generated from the light emitting portion is emitted through the sealing member and the light flux control member in this order,
the light flux control member includes a light incident face into which the light from the light emitting portion enters the light flux control member, and a light control emitting face to control the light emission from the light emitting portion,
concerning the light ranging between a direction to which at least maximum strength light is emitted from the LED and a direction to which one half of strength light of the maximum strength light is emitted, the light control emitting face is formed to satisfy a relation between θ1 and θ5 to be (θ5/θ1) > 1 excluding the light in a vicinity of a reference plane, where the angle formed between the light entering the light flux control member and reaching the light control emitting face, and the line parallel to a reference light axis of the light source module and passing the reaching point is represented by the angle θ1, and an angle of the emission of the light from the light control emitting face is referred to as the angle θ5, and the light control emitting face is formed to be the shape in such fashion that a value of θ5/θ1 is gradually reduced as the θ1 increases.

9. The light box according to claim 1, wherein said receiving concave portion is formed in a reversed multi sided pyramid shape or a reversed multi sided pyramid shape, with a top thereof cut, surrounding said point like light source.

10. The light box according to claim 1, wherein an apex portion of said receiving concave portion is respectively connected to an apex portion of an adjacent receiving concave portion, and an apex portion of said receiving concave portion is located on a location at or below a bisection point of a distance from an emitting portion of said point like light source to said light diffusion surface plate, and at or above an emitting portion of said point like light source.

11. The light box according to claim 1, wherein a diffuse reflectivity of a visible light in the light reflecting plate is at least 80%.

12. The light box according to claim 1, wherein the light reflecting plate comprises a thermoplastic resin film or sheet which has fine foams or pores having an average diameter within the range from at least wavelength of the light to 50 µm inside thereof.

13. The light box according to claim 12, wherein the thermoplastic film or sheet comprises a thermoplastic polyester foam having a thickness of within the range of from 150 to 2000 µm, and a specific gravity of within the range of from 0.1 to 0.7.

14. The light box according to claim 1, wherein a total light ray transmissivity of said light diffusion surface plate is 20-70%.

15. The light box according to claim 1, wherein a depth distance of said case is formed in a range of 40-60 mm, and said plurality of point like light sources are arranged in a matrix having intervals of longitudinal and lateral directions respectively in a range of 80-120 mm.

16. The light box according to claim 1, wherein a depth distance of said case is formed in a range of 20-40 mm, and said plurality of point like light sources are arranged in a matrix having intervals of longitudinal and lateral directions respectively in a range of 40-80 mm.
